(19) Europäisches Patentamt
European Patent Office
Office européen des brevets

(11) **EP 0 473 983 B1**

(12) **EUROPEAN PATENT SPECIFICATION**

(45) Date of publication and mention
of the grant of the patent:
**02.01.1997   Bulletin 1997/01**

(51) Int Cl.[6]: **H01L 33/00**, H01S 3/08

(21) Application number: **91113598.6**

(22) Date of filing: **13.08.1991**

(54) **Light emitting device utilizing cavity quantum electrodynamics**

Lichtemittierende Vorrichtung unter Ausnutzung der Quantenelektrodynamik im Hohlraum

Dispositif électro-luminescent utilisant l'électrodynamique quantique dans une cavité

(84) Designated Contracting States:
**DE FR GB NL**

(30) Priority: **14.08.1990   JP   214812/90**

(43) Date of publication of application:
**11.03.1992   Bulletin 1992/11**

(73) Proprietor: **CANON KABUSHIKI KAISHA**
**Tokyo (JP)**

(72) Inventors:
  • **Okuda, Masahiro, c/o Canon Kabushiki Kaisha**
    **Tokyo (JP)**
  • **Shimizu, Akira, c/o Canon Kabushiki Kaisha**
    **Tokyo (JP)**

(74) Representative:
**Pellmann, Hans-Bernd, Dipl.-Ing. et al**
**Patentanwaltsbüro**
**Tiedtke-Bühling-Kinne & Partner**
**Bavariaring 4**
**80336 München (DE)**

(56) References cited:
**US-A- 4 835 578**

• **PATENT ABSTRACTS OF JAPAN vol. 13, no. 330 (E-793)25 July 1989 & JP-A-1 094 689 ( FURUKAWA ELECTRIC COMPANY LTD ) 13 April 1989**
• **JAPANESE JOURNAL OF APPLIED PHYSICS. vol. 28, no. 11, November 1989, TOKYO JP pages 2101 - 2103; Y.NITTA ET AL.: 'GaAs/AlGaAs OPTICAL**
• **INTERCONNECTION CHIP FOR NEURAL NETWORK'**
• **APPLIED PHYSICS LETTERS. vol. 56, no. 21, 21 May 1990, NEW YORK US pages 2059 - 2061; Y.KAN ET AL.: 'ROOM-TEMPERATURE OPERATION OF THREE TERMINAL QUANTUM-CONFINED FIELD-EFFECT LIGHT EMITTERS'**
• **TRANSACTIONS OF THE INSTITUTE OF ELECTRONICS, INFORMATION vol. E73, no. 1, January 1990, TOKYO JP pages 63 - 69; M.CAO ET AL.: 'LASING ACTION IN GaInAs/ GaInAsP QUANTUM WIRE STRUCTURE'**
• **Applied Physics Letters, vol. 54, no. 4, pages 329 to 331; Y. Tashiro et al.: "Vertical to surface transmission electrophotonic device with selectable output light channels"**

**Description**

BACKGROUND OF THE INVENTION

Field of the Invention

This invention relates to a light emitting apparatus for use as a light source, a light modulator and the like suitable for optical communications, especially, parallel and large capacity optical transmission between electric circuit elements and the like and which have extremely high light emission efficiency, and, more particularly, to light emitting devices utilizing cavity quantum electrodynamics.

Related Background Art

In recent years, technologies for linking the electric circuits using light are expected to overcome the signal delay due to capacitances resulting from electric distribution wires in the large scale integration (LSI), etc. For the purposes of electric linkage, semiconductor lasers have been utilized as light emitting devices. However, the semiconductor laser generally requires a very large injection current density. As a result, integration of many semiconductor lasers on a common substrate causes problems of overheating in the elements and of degraded reliability. As a result, the semiconductor laser is not believed to be suitable as a light emitting device for light transmission between proximate electric circuits.

To solve these problems, there have been developed field-effect type light emission devices having quantum well structures, as is disclosed, for example, in JJAP., vol. 22, pp. L22 -L24 (1982) or in Applied Physics Letters, vol. 56, no. 21, pages 2059-2061. In these devices, the modulation of the number of carriers, done in conventional elements, is not performed, and instead the light emission or radiation rate itself is modulated by spatially separating electrons from holes due to an electric field applied perpendicularly to a quantum well active layer. Therefore, high-speed switching operation is achieved, which is unrelated to the recombination life time of carriers that has been limiting the switching time of the conventional light emitting devices.

Thus, if the above device is utilized as the above-mentioned light emitting device for optical linkage, such optical signal switching becomes possible at very high speed of the order of 10 psec although the injection current density is extremely low. For instance, in the case where a multiplicity of such light emitting devices are arranged on a common substrate, it will be expected that heat generation is low. At the same time excellent characteristics are obtained with respect to the uniformity of light emission and the reliability of the device compared with semiconductor lasers.

An optoelectronic semiconductor element which comprises a surface emitting type laser element and a light modulator coupled to the laser element by an insulating semiconductor layer is described in JP-A-1 094 689.

However, in the prior art field-effect type light emitting device having quantum well, the depth of modulation of light emission is at most about 10:1 to 20:1 since this depth is determined by the ratio between the light emission recombination times at light emission and non-light emission times.

Further, although the internal quantum efficiency (the ratio between the number of injected electrons and the number of generated photons) is very high, there exists the shortcoming that light could not effectively be output, which is a drawback common to such devices that emit spontaneous emission light. In general, this is due to the large refractive index of a semiconductor of the light emission active layer and because total reflection occurs in usual structures.

SUMMARY OF THE INVENTION

An object of this invention is to provide a light emitting device having a structure that achieves a deep depth of modulation or on/off ratio or can supply higher intensity light and so on, utilizing cavity quantum electrodynamics.

This object is achieved by the light emitting device as set out in claim 1. A method of driving said device is described in claim 10.

The advantages will be more readily understood in connection with the following detailed description, claims and drawing.

BRIEF DESCRIPTION OF THE DRAWINGS

Fig. 1 is a schematic sectional view of a first embodiment of this invention.
Fig. 2 is a schematic perspective view of the first embodiment.
Fig. 3A is a view showing the band structure near a light emission active layer of the first embodiment.
Fig. 3B is a view showing the electric field distribution of light radiated in the active layer.
Fig. 4 is a schematic perspective view of a second embodiment of this invention.

DESCRIPTION OF THE PREFERRED EMBODIMENT

It is a basic principle of this invention that the probability of spontaneous emission in the light emitting active layer of a device is greatly enhanced or is changed by a voltage applied to the active layer. In general, the spontaneous emission probability is represented by so-called Fermi's golden rule

$$S = 1/h^2 \cdot \int_0^{\infty} |M(\nu)|^2 \, D(\nu) \, g(\nu) \, d\nu$$

where $M(\nu)$ is the matrix element of an electric dipole interaction Hamiltonian, $D(\nu)$ is the state or mode density of an electromagnetic field or light, $g(\nu)$ is the spectral distribution of an excited electron system. The $M(\nu)$ is a function which is proportional to the sum of a dipole moment of transition from an electron excited state to a ground state and a fluctuation of a vacuum field. In the above stated prior art quantum well field-effect type light emission device, the dipole moment of electron transition of $M(\nu)$ is changed as the means for varying the spontaneous emission probability S.

In sharp contrast thereto, in the present invention, a minute resonator or cavity is constructed for the light radiated in the active layer. As a result, the electromagnetic field of light is quantized. Thus, the fluctuation of a vacuum field of $M(\nu)$ is also set to a certain value or changed, and at the same time $D(\nu)$ is concentrated at a certain frequency. Further, $g(\nu)$ may be shifted in frequency $\nu$ due to the Quantum Confined Stark Effect (QCSE) resulting from the electric field applied to the active layer. As a result, the manner of superposition of $M(\nu)$, $D(\nu)$ and $g(\nu)$ is controlled or changed and hence the spontaneous emission probability can be controlled or greatly changed (see, for example, Japanese Electronic Information Communication Society Journal 9/'89, pp,1014 - 1020, and Physics Today Jan. 1989, pp.24- 30).

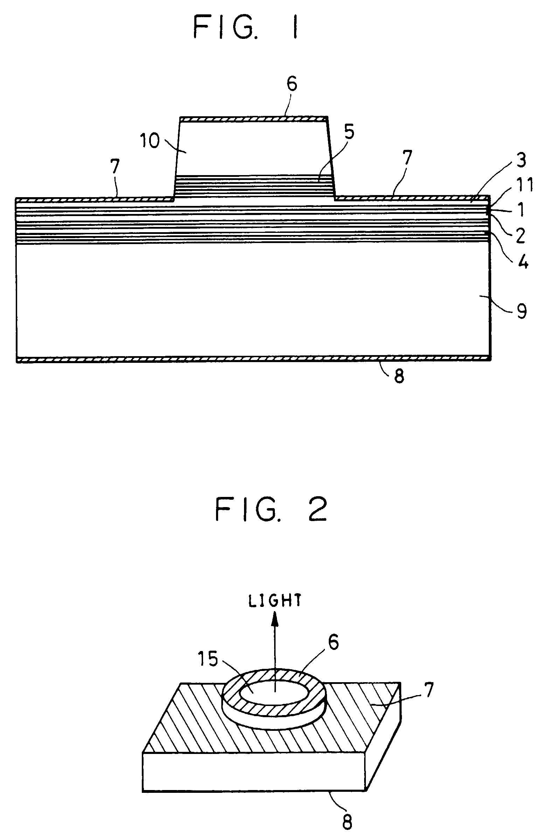

Fig. 1 shows a schematic structure of the first embodiment of this invention. In Fig. 1, reference numeral 1 designates a quantum well of a light emitting active layer which is formed with GaAs of 10 nm thickness. On and under the quantum well 1, an intrinsic (i)-AlAs layer 11 of 10 nm thickness/an i-$Al_{0.2}Ga_{0.8}As$ layer 3 of 105 nm thickness and an n-$Al_{0.2}Ga_{0.8}As$ layer 2 of 113.5 nm thickness respectively layered. The i-AlAs layer 11 acts as a high potential barrier.

This quantum well structure is sandwiched between layers 4 and 5, which respectively consist of twenty (20) periods of an AlAs barrier of 69 nm thickness/a GaAs well of 57.1 nm thickness. Both of these layers 4 and 5 are p-doped.

Further, in Fig. 1, reference numeral 6 is an emitter electrode formed on a cap layer 10, reference numeral 7 is a base electrode formed on the i-layer 3 which is exposed by an etching, and reference numeral 8 is a collector electrode formed on the bottom surface of a substrate 9. The perspective view of the device is depicted in Fig. 2, and light is emitted therefrom through a window IS formed in the emitter electrode 6. This device is fabricated by a conventional molecular beam epitaxy (MBE) process.

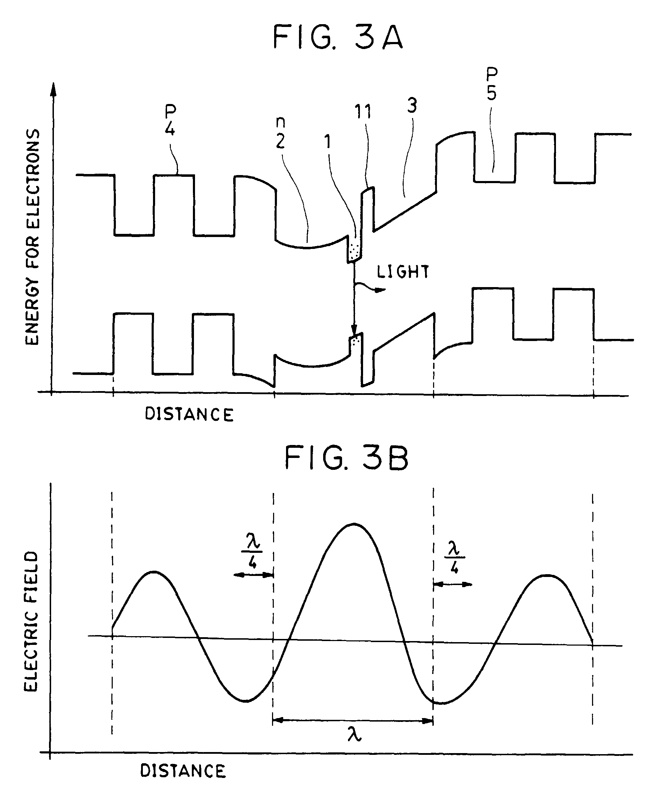

The operation of the first embodiment is as follows. The band structure near the active layer 1 is depicted in Fig. 3A. Holes are injected into the i-$Al_{0.2}Ga_{0.8}As$ layer 3 by a forward bias between the emitter electrode 6 and the base electrode 7, and the holes are captured by the quantum well layer 1 having a low potential for holes to be recombined with electrons, leading to the light emission. On the other hand, an electric field applied to the quantum well layer 1 can be modulated by altering a voltage between the base electrode 7 and the collector electrode 8. Here, since there is the barrier 11 of a high potential between the layer 3 and the light emitting layer 1, the injected holes would not leak to the layer 3 even if a high voltage is applied to the quantum well layer 1.

The device was caused to emit light at liquid-helium temperatures. The wavelength of the light emitted from the quantum well 1 was about 820 nm when no voltage was applied between the base 7 and collector 8, and a half width of light emission was about 2 nm. For this light emission wavelength ($\lambda$), the layers 4 and 5 exhibit an extremely high reflectance because they form a distributed Bragg reflector with their multi-layered films of $\lambda/4$ thickness. Such part as is composed of the layers 1, 2, 3 and 11 has an optical length of an exactly one wavelength $\lambda$. As a result, the electric field amplitude distribution of the light emitted from the quantum well layer 1 becomes as shown in Fig. 3B. Thus, such an electric field has a large amplitude distribution in the light emitting quantum well layer 1. Due to this, the interaction $M(\nu)$ between the atom in the excited state and vacuum field becomes large, so that the transition probability S of the spontaneous emission is enhanced under this condition. In other words, the light emission life time $1/S$ is shortened. According to the experiment, it was confirmed that the light emission probability of this embodiment was increased about twice as much as the conventional light emitting device not having Bragg reflector 4 and 5.

Next, properties thereof will be explained where a reverse bias is applied between the collector 8 and base 7. If the reverse bias is applied, since the electric field is applied to the quantum well layer 1, electrons and holes are spatially separated from each other by the potential in this layer 1. As a result, the dipole moment of the electron transition will be reduced, so the transition probability S of the spontaneous emission is lowered, leading to a long light emission recombination time.

At the same time, the transition energy of the inter-band transition becomes small, so that the light emission wavelength $\lambda$ would try to shift to a longer value. However, this longer wavelength is shifted from the resonance condition, as is seen from Fig. 3B, and thus the electric field amplitude distribution of light would not have a maximum value at the location of the light emission active layer 1. Consequently, the interaction $M(\nu)$ between the atom in the excited state and vacuum field will be further reduced so that the transition probability S of spontaneous emission light will further be lowered, compared to the case where no optical cavity or Bragg reflector exists. Thus, the light emission recombination time is greatly lengthened compared to the case where no reverse bias is applied.

According to the experiment, while, in the case where no Bragg reflector exists, the light emission life time at the time of the reverse bias was about ten times larger than that at the time of no reverse bias. In this embodiment with the Bragg reflector, the light emission life time at the time of the electric field became about fifty (50) times larger than that at the time when no electric field is applied.

As has been explained above, in this embodiment, light and electrons are confined one-dimensionally, and the interaction between the electron system and light or electromagnetic field is controlled in magnitude by altering the excited state of the electron system due to the QCSE. Thus, this embodiment succeeded in greatly varying the spontaneous emission transition probability.

Consequently, it becomes possible to increase the modulation depth or on/off ratio of the light emitting device and strenghten the intensity of light output to the outside.

In the first embodiment, light is confined one-dimensionally by the Bragg reflector. Although this Bragg reflector exhibits a high reflectance for light entering along a perpendicular direction, this reflectance is lower for light entering along oblique directions. Therefore, it is difficult to suppress or strengthen the spontaneous emission of slantwise entering light.

Further, if the temperature is high, the spectral function $g(\nu)$ of electron transition in the quantum well generally has a wider and gentler peak than the mode density $D(\nu)$ of electromagnetic field, in the case of the one-dimensional confinement. As a result, the overlap between $D(\nu)$ and $g(\nu)$ would not greatly vary even if $g(\nu)$ is shifted due to the QCSE, so the light emission probability or the spontaneous emission transition probability would hardly change.

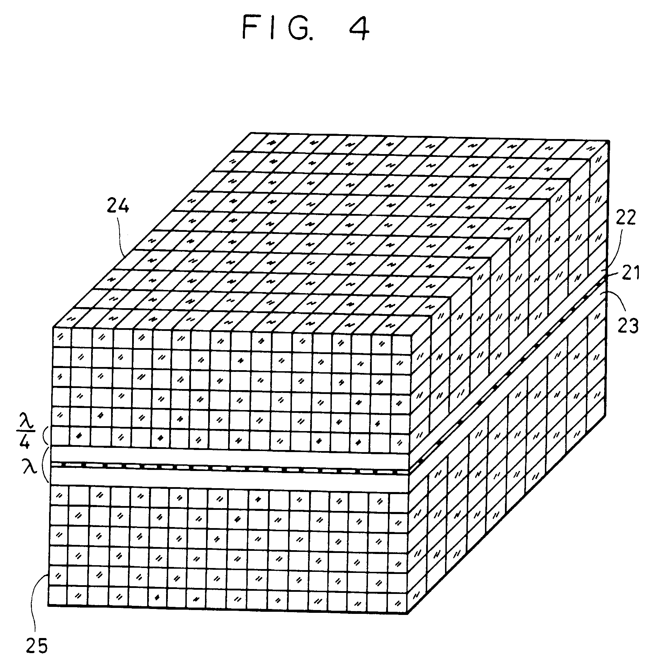

The second embodiment as shown in Fig. 4 overcomes this shortcoming.

In the second embodiment, as compared to the first embodiment, one-dimensional Bragg reflector 4, 5 are replaced by three-dimensional Bragg reflector 24, 25, and the quantum well layer 1 of the active layer is replaced by a layer 21 which involves, for instance, quantum boxes for confining electrons and holes three-dimensionally and broad band-gap material around the quantum boxes. The Bragg reflector 24, 25 is composed of, for example, cubic AlAs and GaAs portions that are alternately formed three-dimensionally and have $\lambda/4$ thicknesses. Between the quantum box layer 21 and the Bragg reflector 24, 25, there are formed layers 22 and 23 like the layers 2 and 3 of the first embodiment. Such part as is constructed by the layers 21, 22 and 23 has an optical length of an exactly one wavelength $\lambda$. Further, emitter, base and collector electrodes are formed in a manner similar to the first embodiment.

As a result, both the state density function $D(\nu)$ of an electromagnetic field and the spectral function $g(\nu)$ of an electron system in the excited state become like a delta function. Therefore, at room temperatures, the breadth of spectrums of state density functions of both the electron and light or electromagnetic field becomes almost equal to zero in principle. So, as the spectral function $g(\nu)$ of the electron system is shifted due to the QCSE caused by applying an electric field or reverse bias to the structure of the quantum box 21, spontaneous emission light will be emitted with an extremely high emission probability when the shape of the spectral function of the electron coincides with that of the light or when their peaks overlap. On the other hand, the spontaneous emission light is almost completely suppressed when the shapes of the spectral functions deviate from each other.

Consequently, by altering the electric field applied to the quantum box layer 21, the spontaneous emission rate can be varied over a very large ratio. In the above embodiments, as a structure for confining lights and electrons, the combination of one-dimensional electron confinement structure or quantum well and one-dimensional light confinement structure or one-dimensional Bragg reflector and the combination of three-dimensional electron confinement structure or quantum box and three-dimensional light confinement structure or three-dimensional Bragg reflector are utilized to construct the light emitting device. But, other combinations can be used within the scope of this invention, and a combination of a two-dimensional electron confinement structure or quantum line and the three-dimensional Bragg reflector and a combination of two appropriate electron and light confinement structures selected from one-, two- and three-dimensional electron and light confinement structures may be used.

Further, in the above embodiments, such Bragg reflectors as have uniform periods are used as a light confinement structure, but there is no limitation to the structure of light confinement, either. Chirped distributed reflectors in which the thickness of each layer is chirped to totally reflect all lights incident thereon at various angles, or mere metal mirrors of low loss, etc., may be used.

Further, in the above embodiments, the pnp type transistor structure is adopted as a structure for injecting current into the quantum confinement structure which is a light emission active layer, but other structures may he used within the concept of this invention. For instance, an npn type transistor structure, such a structure in which the pn junction is formed in a direction in the plane of the substrate for current injection and the pn junction is formed in a direction normal to the substrate for application of an electric field, and the like may be used. Further, such a structure may be employed in which an electric field is applied to the quantum confinement structure using a mere pn junction and light emission carriers are generated by optical pumping.

As has been explained in the foregoing, according to this invention, a light emitting device is achieved in which the electric field effect in the light emission active layer may be utilized and there is provided a reflector having a high reflectance for emitted lights. Thus, the light emission efficiency can be made quite high and an extremely high degree of light modulation can be expected. Further, these excellent characteristics can be attained at a very low current density or excitation rate, so that a power cost per one device can be made extremely small. It thereby becomes possible to construct a short distance optical distribution by layering a multiplicity of such devices. While there has been shown and described what are considered preferred embodiments of the present inventions, it will be obvious to those skilled in the art that various changes and modifications may be made therein without departing from the invention as defined by the claims.

## Claims

1. A light emitting device utilizing cavity quantum electrodynamics comprising:

   an active layer (1;21) for generating and emitting light;
   first means (6,7) for supplying carriers to said active layer (1; 21); and
   second means (7,8) for applying an electric field to said active layer (1;21) to modulate the probability of light emission;

   **said light emitting device being characterized by** reflector means (4,5;24,25) enclosing said active layer (1;21) and having a high reflectance for light generated in said active layer (1;21), said reflector means (4,5;24,25) being a pair of reflectors sandwiching the active layer (1;21), and the distance between said reflectors being equal to the wavelength of the light generated in the active layer (1;21) without an electric field being applied.

2. A light emitting device according to Claim 1,
   **characterized in that** said active layer (1;21) comprises a quantum well for confining carriers one-dimensionally.

3. A light emitting device according to Claim 1,
   **characterized in that** said active layer (1;21) comprises a quantum line for confining carriers two-dimensionally.

4. A light emitting device according to Claim 1,
   **characterized in that** said active layer (1;21) comprises a quantum box for confining carriers three-dimensionally.

5. A light emitting device according to Claim 1,
   **characterized in that** said reflector means (4,5;24,25) comprises a one-dimensional distributed Bragg reflector.

6. A light emitting device according to Claim 1,
   **characterized in that** said reflector means (4,5;24,25) comprises a three-dimensional distributed Bragg reflector being a reflector with a three-dimensional regular internal structure.

7. A light emitting device according to Claim 1,
   **characterized in that** said reflector means (4,5;24,25) comprises a chirped distributed reflector.

8. A light emitting device according to Claim 1,
   **characterized in that** said reflector means (4,5;24,25) comprises a metal mirror of low loss.

9. A light emitting device according to Claim 1,
   **characterized in that** said first means (6,7) for supplying carriers to said active layer (1; 21) is part of a transistor structure for injecting current into said active layer (1;21).

10. A method for driving the light emitting device according to any of the preceding Claims 1 to 9 comprising the steps of:

supplying carriers to said active layer (1;21) by said first means (6, 7); and
applying an electric field to said active layer (1;21) by said second means (7, 8);

11. A method according to claim 10, **characterized in that** said supplying of carriers to said active layer (1;21) is realized by optical pumping.

**Patentansprüche**

1. Lichtemittierende Vorrichtung unter Ausnutzung der Quantenelektrodynamik im Hohlraum, umfassend:

    eine aktive Schicht (1; 21) zum Erzeugen und Emittieren von Licht;
    erste Einrichtungen (6, 7) zum Zuführen von Ladungsträgern zu der aktiven Schicht (1; 21); und
    zweite Einrichtungen (7, 8) zum Anlegen eines elektrischen Feldes an die aktive Schicht (1; 21) zum Modulieren der Wahrscheinlichkeit der Lichtemission; wobei die lichtemittierende Vorrichtung **gekennzeichnet ist durch**
    Reflektoreinrichtungen (4, 5; 24, 25), die die aktive Schicht (1; 21) einschließen und ein hohes Reflexionsvermögen für in der aktiven Schicht (1; 21) erzeugtes Licht haben, wobei die Reflektoreinrichtungen (4, 5; 24, 25) ein Reflektorenpaar sind, die die aktive Schicht (1; 21) sandwichartig umgeben, und der Abstand zwischen den Reflektoren gleich der Wellenlänge des in der aktiven Schicht (1; 21) ohne angelegtes elektrisches Feld erzeugten Lichts ist.

2. Lichtemittierende Vorrichtung nach Anspruch 1,
    **dadurch gekennzeichnet, daß**
    die aktive Schicht (1; 21) einen Quantentopf umfaßt, um Ladungsträger eindimensional einzuschließen.

3. Lichtemittierende Vorrichtung nach Anspruch 1,
    **dadurch gekennzeichnet, daß**
    die aktive Schicht (1; 21) einen Quantendraht umfaßt, um Ladungsträger zweidimensional einzuschließen.

4. Lichtemittierende Vorrichtung nach Anspruch 1,
    **dadurch gekennzeichnet, daß**
    die aktive Schicht (1; 21) eine Quantenbox umfaßt, um Ladungsträger dreidimensional einzuschließen.

5. Lichtemittierende Vorrichtung nach Anspruch 1,
    **dadurch gekennzeichnet, daß**
    die Reflektoreinrichtungen (4, 5; 24, 25) einen eindimensionalen Reflektor mit verteilter Bragg-Reflexion umfassen.

6. Lichtemittierende Vorrichtung nach Anspruch 1,
    **dadurch gekennzeichnet, daß**
    die Reflektoreinrichtungen (4, 5; 24, 25) einen dreidimensionalen Reflektor mit verteilter Bragg-Reflexion umfassen, der ein Reflektor mit einer dreidimensionalen regelmäßigen inneren Struktur ist.

7. Lichtemittierende Vorrichtung nach Anspruch 1,
    **dadurch gekennzeichnet, daß**
    die Reflektoreinrichtungen (4, 5; 24, 25) einen Reflektor mit verteilter Chirp-Modulation umfassen.

8. Lichtemittierende Vorrichtung nach Anspruch 1,
    **dadurch gekennzeichnet, daß**
    die Reflektoreinrichtungen (4, 5; 24, 25) einen Metallspiegel mit niedrigem Verlust umfassen.

9. Lichtemittierende Vorrichtung nach Anspruch 1,
    **dadurch gekennzeichnet, daß**
    die erste Einrichtung (6, 7) zum Zuführen von Ladungsträgern zu der aktiven Schicht (1; 21) ein Teil einer Transistorstruktur zum Injizieren von Strom in die aktive Schicht (1; 21) ist.

10. Verfahren zum Betreiben der lichtemittierenden Vorrichtung nach einem der vorhergehenden Ansprüche 1 bis 9, umfassend die Schritte zum:

Zuführen von Ladungsträgern zu der aktiven Schicht (1; 21) durch die erste Einrichtung (6, 7); und
Anlegen eines elektrischen Feldes an die aktive Schicht (1; 21) durch die zweite Einrichtung (7, 8).

**11.** Verfahren nach Anspruch 10,
**dadurch gekennzeichnet, daß**
das Zuführen von Ladungsträgern zu der aktiven Schicht (1; 21) durch optisches Pumpen verwirklicht wird.

**Revendications**

**1.** Dispositif émetteur de lumière utilisant l'électrodynamique quantique d'une cavité comprenant :

une couche (1;21) active pour générer et émettre de la lumière ;
des premiers moyens (6,7) pour fournir des porteurs à ladite couche (1;21) active ; et
des seconds moyens (7, 8) pour appliquer un champ électrique à ladite couche (1;21) active afin de moduler la probabilité d'émission de lumière ;
ledit dispositif émetteur de lumière étant caractérisé par
des moyens (4,5;24,25) réflecteurs entourant ladite couche (1;21) active et ayant une réflectance élevée pour de la lumière générée dans ladite couche (1;21) active, lesdits moyens (4,5;24,25) réflecteurs étant une paire de réflecteurs prenant en sandwich la couche (1;21) active, et la distance entre lesdits réflecteurs étant égale à la longueur d'onde de la lumière générée dans la couche (1;21) active sans qu'un champ électrique soit appliqué.

**2.** Dispositif émetteur de lumière selon la revendication 1,
caractérisé en ce que ladite couche (1;21) active comprend un puits quantique pour confiner des porteurs de manière monodimensionnelle.

**3.** Dispositif émetteur de lumière selon la revendication 1,
caractérisé en ce que ladite couche (1;21) active comprend une ligne quantique pour confiner des porteurs de manière bidimensionnelle.

**4.** Dispositif émetteur de lumière selon la revendication 1, caractérisé en ce que ladite couche (1;21) active comprend une boîte quantique pour confiner des porteurs de manière tridimensionnelle.

**5.** Dispositif émetteur de lumière selon la revendication 1,
caractérisé en ce que lesdits moyens (4,5;24,25) réflecteurs comprennent un réflecteur de Bragg distribué monodimensionnel.

**6.** Dispositif émetteur de lumière selon la revendication 1,
caractérisé en ce que lesdits moyens (4,5;24,25) réflecteurs comprennent un réflecteur de Bragg distribué tridimensionnel qui est un réflecteur ayant une structure interne régulière tridimensionnelle.

**7.** Dispositif émetteur de lumière selon la revendication 1,
caractérisé en ce que lesdits moyens (4,5;24,25) réflecteurs comprennent un réflecteur distribué à pas variable.

**8.** Dispositif émetteur de lumière selon la revendication 1,
caractérisé en ce que lesdits moyens (4,5;24,25) réflecteurs comprennent un miroir métallique à faible perte.

**9.** Dispositif émetteur de lumière selon la revendication 1,
caractérisé en ce que lesdits premiers moyens (6,7) destinés à fournir des porteurs à ladite couche (1;21) active font partie d'une structure de transistor destinée à injecter un courant dans ladite couche (1;21) active.

**10.** Procédé pour attaquer le dispositif émetteur de lumière selon l'une quelconque des revendications 1 à 9 précédentes, comprenant les étapes qui consistent :

à fournir des porteurs à ladite couche (1;21) active à l'aide desdits premiers moyens (6,7) ; et
à appliquer un champ électrique à ladite couche (1;21) active à l'aide desdits seconds moyens (7,8).

**11.** Procédé selon la revendication 10,
caractérisé en ce que ladite fourniture de porteurs à ladite couche (1;21) active est réalisée par pompage optique.

# FIG. 1

# FIG. 2

LIGHT

# FIG. 3A

# FIG. 3B

# FIG. 4